# EUROPÄISCHE PATENTANMELDUNG

(11) **EP 0 689 249 A2**
(43) Veröffentlichungstag der Anmeldung: **27.12.1995**
(21) Anmeldenummer: 95201577.4
(22) Anmeldetag: 14.06.1995
(51) Int. Cl.: H01L 29/43

(54) **Elektrodenschicht für elektronisches Bauteil und Verfahren zu seiner Herstellung**

(30) Priorität: 18.06.1994 DE 4421007
(71) Anmelder: Philips Patentverwaltung GmbH, 22335 Hamburg (DE); Philips Electronics N.V., 5621 BA Eindhoven (NL)
(72) Erfinder: Klee, Mareike Katharine, Dr., c/o Philips, D-20097 Hamburg (DE); Brand, Hans-Wolfgang, c/o Philips, D-20097 Hamburg (DE); Jungk, Hans-Otto, c/o Philips, D-20097 Hamburg (DE)
(74) Vertreter: Walz, Erich

(57) **Zusammenfassung**

Die Erfindung betrifft ein elektronisches Bauteil, z.B. diskrete Bauelemente oder multifunktionelle Mehrkomponentensysteme wie nichtflüchtige ferroelektrische Speicher, dynamische Schreib-Lese-Speicher mit wahlfreiem Zugriff, integrierte Kondensatoren, Dünnschichtaktuatoren, Dünnschichtwiderstände, piezoelektrische Sensoren, piezoelektrische Wandler, pyroelektrische Sensoren, elektrooptische Bauelemente oder Module mit integrierten passiven Bauelementen (ICM) mit einem Substrat, mit Elektrodenschichten für Unterelektrode, Deckelektrode und gegebenenfalls ein oder mehreren Zwischenelektroden und mit funktionellen Zwischenschichten, wobei die Elektrodenschichten elektrisch leitende, oxidische Verbindungen enthalten, dadurch gekennzeichnet, daß mindestens eine Elektrodenschicht aus TiOₓ mit 1≦x≦2, EuOₓ mit 1≦x≦2, LiTi₂O₄, LiV₂O₄, SrVO₃, ErₓNbO₃ mit 0,65≦x≦0,92, RbWO₃, NaₓWO₃, A₂P₈W₃₂O₁₁₂ mit A=K,Rb,Tl, NaₓTa_{y}W_{1-y}O₃ mit x=0.64 und x-y= 0.18, Na₁₋ₓSrₓNbO₃, LaTiO₃ CeTiO₃, CaVO₃, La₁₋ₓSrₓVO₃, SrCoO₃, CaRuO₃, SrRuO₃, BaRuO₃, BaPbO₃, SrMoO₃, Sr_{0.5}La_{0.5}O₃, La₄BaCu₅O₁₃₋ₓ, La₂₋ₓSrₓCuO_{4-δ}, YBa₂Cu₃O_{7-δ}, Bi₂Sr₂CaCu₂O_{8+d}, Bi₂Sr₂CuO_{6+d}, Bi₂Sr₂Ca₂Cu₃O_{10+d}, Tl₂Ba₂CaCu₂O₈, TlBa₂CuO_{6+d}, Tl₂Ba₂Ca₂Cu₃O_{10+d}, La₄BaCu₆O₁₅, Gd₁₋ₓSrₓVO₃, CaCrO₃, SrFeO₃, EuNbO₃, SrIrO₃, CaMoO₃, BaMoO₃, Bi₃Ru₃O₁₁, VO₂, CrO₂, MoO₂, WO₂, RhO₂, PtO₂, RuOₓ mit 1,5≦x<2, IrOₓ mit 1,5≦x≦2, SnO₂₋ₓ, La₃Ni₂O₇, La₃Ni₃O₁₀, M₂V₂O₇₋ₓ mit M=Tm, Lu, M₂Mo₂O₇ mit M=Nd,Sm,Gd, Lu₂Ru₂O₇, Pb₂Ru₂O₇, Bi₂Ru₂O₇, Pb₂Os₂O₇, Tl₂Os₂O₇, Pb₂Ir₂O₂, Tl₂Rh₂O₇₋ₓ, K_{0.3}MoO₃, Rb_{0.3}MoO₃, Tl_{0.3}MoO₃ MₓV₂O₅ mit M=Cu,Na, Mo₁₇O₄₇ oder Tl₂O₃₋ₓ oder aus physikalischen Mischungen und/oder festen Lösungen miteinander oder mit ≦ 50 Gew.-% von weiteren Verbindungen oder Metallen besteht. Diese Elektrodenschicht zeichnet sich durch eine verbesserte Haftung aus und passiviert sich nicht. Ein verbessertes Verfahren zu ihrer Herstellung ist angegeben.

## Beschreibung

Die Erfindung betrifft ein elektronisches Dünnschichtbauteil mit einem Substrat, mit Elektrodenschichten für Unterelektrode, Deckelektrode und gegebenenfalls ein oder mehreren Zwischenelektroden und mit funktionellen Zwischenschichten, wobei die Elektrodenschichten elektrisch leitende, oxidische Verbindungen enthalten.

Solche Bauteile können diskrete Bauelemente oder multifunktionelle Mehrkomponentensysteme wie nichtflüchtige ferroelektrische Speicher, dynamische Schreib-Lese-Speicher mit wahlfreiem Zugriff, integrierte Kondensatoren, Dünnschichtaktuatoren, Dünnschichtwiderstände, piezoelektrische Sensoren, piezoelektrische Wandler, pyroelektrische Sensoren, elektrooptische Bauelemente oder Module mit integrierten passiven Bauelementen (ICM) sein.

Beispielsweise werden für Anwendungen in nichtflüchtigen, ferroelektrischen Speichern, in piezoelektrische Wandlern, Sensoren und Aktuatoren sowie pyroelektrischen Sensoren funktionelle Schichten aus Perowskiten der Zusammensetzung PbZrₓTi₁₋ₓO₃ mit x=0.3-0.7, sowie Pb_{1-1.5y}La_{y}ZrₓTi₁₋ₓO₃ mit y=0.03-0.07, x=0.4-0.6, Pb_{1-1.5y}La_{y}TiO₃-Schichten mit y=0.05-0.16 zwischen Elektroden gestapelt. Hochfrequenzmodule für Filteranwendungen nach dem Stand der Technik mit Kondensatoren und Widerständen enthalten als funktionelle Schichten Kombinationen von SiO₂ mit Si₃N₄.

In diesen und anderen Dünnschichtbauteilen wird Platin als Elektrodenmaterial gegenüber anderen Elektrodenmaterialien wie Cu, Al, oder Ag/Pd bevorzugt, um Reaktionen des Elektrodenmaterials mit dem Material für die funktionellen Schichten, beispielsweise Perowskiten, bei dessen Sinterung während der Herstellung unter Sauerstoffatmosphäre bei 600-800°C zu verhindern. Problematisch ist dabei jedoch die Verbindung der Platinelektrode zum Substrat. Um eine gute Haftung der Pt-Elektrodenschichten auf einem üblichen Substrat wie Silizium mit SiO₂-Isolations-schichten zu erzeugen, muß zusätzlich eine Adhäsionsschicht, beispielsweise eine dünne Ti-Schicht, als Zwischenschicht zwischen Si/SiO₂ und Pt angebracht werden. Auch bei optimierten Elektroden- und Adhäsionsschichten reicht die Haftung der Pt-Elektroden nach der Sinterung der Perowskitschichten häufig nicht mehr aus. Dies führt dazu, daß sich der gesamte Kondensatoraufbau einschließlich Unterelektrode während der Nachbehandlung vom Substrat abgelöst. Deswegen können noch für viele Anwendungsfälle keine Bauteile mit hoher Zuverlässigkeit hergestellt werden.

Neben der Integration von Perowskitschichten in Halb-leiter-ICs für z.B. integrierte Kondensatoren, ferroelektrische, nichtflüchtige Speicher oder Schreib-Lese-Speichern mit wahlfreiem Zugriff, sowie für pyroelektrische und piezoelektrische Bauelemente, haben Perowskitschichten unter anderem auch Bedeutung zur Herstellung von Modulen mit integrierten passiven Bauteilen. Perowskitschichten dienen hier als Dielektrika in Dünnschichtkondensatoren und werden zwischen Elektroden wie z.B. Pt-Elektroden abgeschieden. Auch hier ist wiederum die schlechte Haftung von Platinschichten gegenüber Substratmaterialien wie Si/SiO₂ oder Al₂O₃ und gegenüber funktionellen Schichten wie oxidische Perowskitschichten mit Pb_{1-1.5y}La_{y}ZrₓTi₁₋ₓO₃ mit 0.53<x<1 und y=0.05-0.15 oder Pb(Mg,Nb)ₓTi₁₋ₓO₃ mit 0.6 5<x<1 ein deutlicher Nachteil.

Ein weiterer Nachteil der Ti/Pt-Elektrodenschichten ist es, daß dieses Materialsystem nur mittels Vakuumtechniken wie z.B. Kathodenstrahlzerstäubung oder Elektronenstrahlverdampfung abgeschieden werden kann. Diese Verfahren bedeuten jedoch hohe Investitionskosten wie auch hohe Betriebskosten, da z.B. im Falle eines Kathodenstrahlverfahrens teure Pt-Targets angeschafft werden müssen.

Perowskitschichten wie z.B. PbZrₓTi₁₋ₓO₃ mit x=0.2-0.7 auf Si-Substraten mit einer Ti-Adhäsionsschicht und einer Pt-Schicht als Unterelektrode sowie einer Pt-Schicht als Oberelektrode haben Bedeutung für eine neue Klasse von Speichern, für ferroelektrische nichtflüchtige Speicher. Eine Vielzahl von Untersuchungen haben jedoch gezeigt, daß solche ferroelektrische Speicherzellen je nach Abscheidebedingungen mehr oder weniger starke Ermüdungserscheinungen zeigen. Die geschaltete Ladung solcher ferroelektrischer Speicherzellen nimmt nach einigen hundert Schaltcyclen deutlich ab, die Speicherzellen sind dann nicht mehr funktionstüchtig. Obwohl die Phänomene, welche für die Ermüdungserscheinungen in diesen Materialien verantwortlich sind, noch nicht geklärt sind, sind anderere Elektrodenmaterialien in Kombination mit den bekannten funktionellen Schichten zur Eliminierung der Ermüdungserscheinungen notwendig.

Zur Abhilfe ist bereits in der EP-A-0 495 114 ein Halbleiterbauteil vorgeschlagen worden, bei dem ein ferroelektrischer Film, der auf einem Halbleitersubstrat ein aktives Element bildet, auf diesem mittels Elektroden integriert wird, die mit dem ferroelektrischen Film einen Schichtverbund bilden, wobei eine oder beide der Elektroden, die den Schichtverbund bilden, ein oxidischer Leiter ist, der im wesentlichen aus entweder ITO (Mischkristall aus Indiumoxid und Zinnoxid), Rutheniumoxid, Rheniumoxid, Wolframoxid, Chromoxid oder Molybdänoxid besteht. Als Verfahren zur Herstellung dieser Oxidelektroden wird die Sputtertechnik angegeben. Mit Ausnahme der ITO-Schicht sind diese Oxidschichten jedoch sehr spröde und zum Teil auch wenig leitfähig.

Aufgabe der vorliegenden Erfindung ist daher die Schaffung eines elektronischen Dünnschichtbauteils mit verbesserten Elektrodenschichten, die besser haften, elektrisch gut leiten und keine Ermüdungserscheinungen zeigen, sowie eines Verfahrens zur Herstellung eines solchen Dünn schichtbauteils.

Diese Aufgabe wird erfindungsgemäß dadurch gelöst, daß mindestens eine Elektrodenschicht aus TiOₓ mit 1≦x≦2, EuOₓ mit 1≦x≦2, LiTi₂O₄, LiV₂O₄, SrVO₃, ErₓNbO₃ mit 0,65≦x≦0,92, RbWO₃, NaₓWO₃, A₂P₈W₃₂O₁₁₂ mit A=K, Rb,Tl, NaₓTa_{y}W_{1-y}O₃ mit x=0.64 und x-y= 0.18, Na₁₋ₓSrₓNbO₃, LaTiO₃ CeTiO₃, CaVO₃, La₁₋ₓ SrₓVO₃, SrCoO₃, CaRuO₃, SrRuO₃, BaRuO₃, BaPbO₃, SrMoO₃, Sr_{0.5}La_{0.5}O₃, La₄BaCu₅O₁₃₋ₓ, La₂₋ₓSrₓCuO_{4-δ}, YBa₂Cu₃O_{7-δ}, Bi₂Sr₂CaCu₂O_{8+d}, Bi₂Sr₂CuO_{6+d}, Bi₂Sr₂Ca₂Cu₃O_{10+d}, Tl₂Ba₂CaCu₂O₈, TlBa₂CuO_{6+d}, Tl₂Ba₂Ca₂Cu₃O_{10+d}, La₄BaCu₆O₁₅, Gd₁₋ₓSrₓVO₃, CaCrO₃, SrFeO₃, EuNbO₃, SrIrO₃, CaMoO₃, BaMoO₃, Bi₃Ru₃O₁₁, VO₂, CrO₂, MoO₂, WO₂, RhO₂, PtO₂, RuOₓ mit 1,5≦x<2, IrOₓ mit 1,5≦x≦2, SnO₂₋ₓ, La₃Ni₂O₇, La₃Ni₃O₁₀, M₂V₂O₇₋ₓ mit M=Tm, Lu, M₂Mo₂O₇ mit M=Nd,Sm,Gd, Lu₂Ru₂O₇, Pb₂Ru₂O₇, Bi₂Ru₂O₇, Pb₂Os₂O₇, Tl₂Os₂O₇, Pb₂Ir₂O₂, Tl₂Rh₂O₇₋ₓ, K_{0.3}MoO₃, Rb_{0.3}MoO₃, Tl_{0.3}MoO₃ MₓV₂O₅ mit M=Cu,Na, Mo₁₇O₄₇ oder Tl₂O₃₋ₓ oder aus physikalischen Mischungen und/oder festen Lösungen besagter oxidischer Verbindungen miteinander oder mit ≦ 50 Gew.-% von weiteren Verbindungen oder Metallen besteht.

Diese Elekrodenschichten zeigen eine verbesserte Haftung, weil sie sehr duktile, flexible Schichten bilden, die auch bei größeren Schichtdicken nicht "stauben". Die Ursache hierfür liegt vermutlich in der leichten Bildung von anorganisch-oxidischen Reaktionsschichten an den Grenzflächen zum Substrat bzw. auch zu den funktionellen Schichten. Aufgrund der guten Verbindung zum Untergrund ist der Übergangswiderstand gering, es treten keine Spannungsspitzen auf und auch nach längeren Betriebszeiten findet keine Passivierung an der Grenzfläche statt.

Die erfindungsgemäßen elektrisch leitfähigen oxidischen Verbindungen zeichnen sich durch eine besonders hohe spezifische Leitfähigkeit aus. Sie können bei niedrigen Temperaturen hergestellt werden und zeigen keine schädlichen Wechselwirkungen mit den üblichen funktionellen Schichten nach dem Stand der Technik.

Im Rahmen der vorliegenden Erfindung kann es bevorzugt sein, daß die in den Elektrodenschichten enthaltenen weiteren Verbindungen RuO₂ oder ReO₃ sind. Auch wenn diese Verbindungen als kompakte Schichten eine schlechte Haftung zeigen, können Elektrodenschichten mit einem Anteil an RuO2 für elektrooptische Anwendungen und solche mit einem Anteil an ReO₃ für Speicheranwendungen besonders geeignet sein.

In einer weiteren bevorzugten Ausführungsform sind die in den Elektrodenschichten enthaltenen weiteren Verbindungen TiO₂, SiO₂ oder Al₂O₃. Diese erhöhen die Duktilität der Elektrodenschichten durch Netzwerkbildung zusätzlich.

Es kann weiterhin bevorzugt sein, daß eine in den Elektrodenschichten enthaltene weitere Verbindung SnO₂ ist. Diese verbessert die mechanische Festigkeit der Elektrodenschicht und erleichtert die Abscheidung nachfolgender Schichten.

Im Rahmen der vorliegenden Erfindung kann es bevorzugt sein, daß die in der Elektrodenschicht im physikalischen Gemisch mit den erfindungsgemäßen oxidischen Verbindungen enthaltenen Metalle Platin, Palladium, Iridium, Gold, Silber und/oder Kupfer oder deren Legierungen sind. Diese erhöhen die Leitfähigkeit der Elektrode und verbessern gleichzeitig die Morphologie der Schicht, sodaß die Neigung zur Bildung von Haarrissen bei der abschließenden Temperaturbehandlung unterdrückt wird.

Die erfindungsgemäße Elektrodenschicht ist besonders für elektronische Dünnschichtbauteile geeignet, deren funktionelle Zwischenschichten Perowskite enthalten. Im Vergleich zu den metallischen Elektrodenschichten nach dem Stand der Technik ist die gegenseitige Benetzung der Elektrodenschichten mit den erfindungsgemäßen oxidischen Verbindungen und den funktionellen Perowskiten sehr gut und der Unterschied in den thermischen Ausdehnungskoeffizienten gering.

Es ist bevorzugt, daß das Substrat des elektronischen Dünnschichtbauteils aus Si, GaAs, Saphir , Glas , Quarz, ZrO₂, MgO, Al₂O₃ oder AlN besteht. Die Haftung der Elektrodenschichten mit den erfindungsgemäßen oxidischen Verbindungen zu den konventionellen Isolationsschichten auf den Substraten aus Si oder GaAs, die ebenfalls aus oxidischen Verbindungen bestehen, ist sehr gut. Gleiches gilt für die oxidischen Substrate wie MgO, Al₂O₃, Glas, Quarz, ZrO₂ oder Saphir.

Das Verfahren zur Herstellung des erfindungsgemäßen elektronischen Dünnschichtbauteils ist dadurch gekennzeichnet, daß eine oder mehrere Elektrodenschichten durch Beschichten eines Substrates oder einer funktionellen Zwischenschicht mit echten Lösungen, Solen oder Suspensionen, die Ausgangsverbindungen für die elektrisch leitenden oxidischen Verbindungen enthalten, mittels eines naßchemischen Depositionsverfahrens und anschließender thermischen Behandlung zur Bildung der elektrisch leitenden oxidischen Verbindungen erzeugt werden.

Ein solches Verfahren hat eine Reihe von Vorteilen. Erstens ist es durch dieses Verfahren einfach, eine Elektrodenschicht zu erzeugen, die oxidische Verbindungen, Mischkristalle oder physikalische Gemische von mehr als einem Element enthält, indem man einfach die jeweiligen Ausgangsverbindungen mischt und eine Co-Deposition durchführt. Zweitens erhält man leicht sehr dünne Filme von weniger als 200 nm Stärke. Drittens sind die so abgeschiedenen Filme unempfindlich gegenüber Temperaturwechselbelastung, während Filme, die durch Elektroplattierung, Sputtern, CVD oder PVD abgeschieden wurden, generell leicht delaminieren, wenn sie erwärmt werden.

Bevorzugt ist es, daß die Ausgangsverbindungen metallo-organische Verbindungen oder nitrat-, halogenid- oder hydroxidhaltige Verbindungen sind. Metallo-organische Verbindungen lassen sich leicht miteinander mischen, müssen jedoch kontrolliert im Sauerstoffstrom eingebrannt werden, um Kohlenstoffeinschlüsse zu verhindern. Besonders die nitrathaltigen Verbindungen haben den Vorteil, daß sie sich bei sehr niedrigen Temperaturen zersetzen und dabei oxidierende Gase zur Reaktion beisteuern, die die Bildung der oxidischen, leitfähigen Verbindungen beschleunigen.

Im Rahmen der vorliegenden Erfindung ist es bevorzugt, daß das naßchemische Depositionsverfahren ein Schleuderverfahren ist. Durch das Schleudern erhält man besonders glatte, dünne und schlierenfreie Schichten.

Es ist weiterhin bevorzugt, daß die Beschichtung in mehreren Schichten aufgetragen wird, da dies die Duktilität der Schichten erhöht.

Es kann bevorzugt sein, daß die Mehrfachschichten unterschiedliche Zusammensetzungen haben, um sie dem Substrat bzw. den funktionellen Schichten besser anpassen zu können.

Es kann auch bevorzugt sein, daß die Beschichtung bei erhöhter Temperatur aufgetragen wird. Dies ist besonders vorteilhaft für Elektrodenschichten, die beim Sintern noch stark schrumpfen. Im allgemeinen wird es jedoch als vorteilhaft angesehen, daß das Verfahren bereits bei überraschend erniedrigten Temperaturen kristalline Elektrodenschichten erzeugt und dadurch die thermische Belastung des Bauteils klein bleibt.

Es ist weiterhin bevorzugt, daß auch die funktionellen Schichten mittels eines naßchemischen Depositionsverfahrens und anschließender thermischer Behandlung erzeugt werden. Einerseits wird dadurch das Verfahren einfach und kostengünstig, andererseits lassen sich die so abgeschiedenen Schichten bei sehr niedrigen Temperaturen sintern, wodurch die thermische Belastung des gesamten Verbundes aus Substrat, Elektrodenschichten und funktionellen Schichten während der Fertigung erniedrigt wird.

Nachfolgend wird die Erfindung weiter erläutert. Für das erfindungsgemäße naßchemische Depositionsverfahren zur Herstellung von leitenden oxidischen Elektrodenschichten werden metallo-organische Ausgangsverbindungen oder nitrat-, chlorid- oder hydroxidhaltige Verbindungen, die sich zu den gewünschten Verbindungen zersetzen, ausgewählt. Als anorganische Verbindungen verwendet man mit Vorteil Nitrosylnitrate wie Rutheniumnitrosylnitrat, Nitrosylhalogenide, Oxynitrate, Hydroxynitrat oder Acetate wie Bleiacetat, die sich in organischen Lösungsmitteln lösen. Als metallo-organische Verbindungen stehen eine große Anzahl von Verbindungen wie z.B. Acetate oder Salze von Fettsäuren (Carboxylate), Alkoxide und β-Diketonate zur Verfügung, sodaß das Verfahren sehr flexibel ist. Die metallo-organischen Verbindungen können auch erst in situ durch Umsetzung der Nitrate, Chloride, Hydroxide u.ä. mit Alkoholen, Fettsäuren, Aldehyden, Ketonen usw. gewonnen werden. Zur Abscheidung der Metalle können auch sehr vorteilhaft die handelsüblichen Resinate eingesetzt werden. Soweit z.B. die metallo-organischen Verbindungen flüssig sind, können sie direkt miteinander gemischt werden. Üblicherweise werden jedoch die Ausgangsverbindungen in einem gemeinsamen Lösungsmittel, wie Isopropanol, n-Butanol, Xylol o.ä. aufgelöst. Dabei können die Viskositäten der Lösungen zwischen 25 Centipoises und 800 Poises aufweisen, und deren Trocknungseigenschaften und Thixotropie nach Wunsch eingestellt werden kann. Zu den Verfahren mit metallo-organischen Verbindungen zählt das Sol-Gel-Verfahren und die **M**etallo-**O**rganische-**D**eposition (MOD). Das MOD-Verfahren verwendet Ausgangssubstanzen mit höheren Molekulargewichten, z.B. Oktanoate und Dekanoate, die gegenüber der Hydrolysereaktion weniger empfindlich sind als die Substanzen des Sol-Gel-Verfahrens. Eine wesentlich einfachere Prozeßführung ist damit möglich.

Diese Lösungen werden auf ein Substrat aufgetragen. Typischerweise besteht das Substrat aus einkristallinem oder polykristallinem Silizium, es kann aber auch aus einem anderen bekanntem Substratwerkstoff wie Glas, Quarz, Saphir, Galliumarsenid, MgO, ZrO₂, Al2O3 oder AlN bestehen.

Nach dem bekannten Stand der Technik werden Siliziumsubstrate mit einer SiO2-Schicht zur Isolation, Al₂O₃- Substrate mit einer Glasschicht zur Glättung, andere Substrate beispielsweise mit Haftschichten aus Palladium oder Titanlegierungen überzogen. Im Rahmen der vorliegenden Erfindung sollen unter "Substrat" auch derartig vorbehandelte Substrate verstanden werden.

Die Beschichtung des Substrates kann durch ein Schleuderverfahren (Spin-On-Process), Tauchen, Spritzen oder Walzenauftrag erfolgen.

Die deponierten Schichten sind zunächst amorph und enthalten Lösungsmittel und Alkolatgruppen bzw. andere organische oder anorganische Reste. Zur Bildung der keramischen Elektrodenschichten ist eine Temperaturbehandlung erforderlich, während der unterschiedliche Umwandlungsphasen in den Elektrodenschichten ablaufen. Zu Beginn des Temperaturprozesses trocknet die Schicht und Lösungsmittel werden verflüchtigt. Bei weiterer Temperaturerhöhung werden die organischen und anorganischen Reste in einer Pyrolysereaktion freigesetzt. Die Schicht wird dabei in einen anorganischen Film umgewandelt. Üblicherweise wird die thermische Zersetzung der Ausgangsverbindungen in oxidierender Atmosphäre, d.h. in Sauerstoff oder Luft, durchgeführt. Unter diesen Bedingungen bilden nur die Edelmetalle Platin, Palladium, Iridium, Silber, Gold, Kupfer und deren Legierungen metallische Filme. Andere Elemente scheiden sich als Oxide ab. Anschließend erfolgt eine Verdichtung der Gel-Struktur. Ab 400°C setzt Kornwachstum ein und die Kristallalisation in die gewünschte Mikrostruktur beginnt. Auf diese Art und Weise können Elektrodenschichten mit komplexen oxidischen Systemen mit verbesserten Eigenschaften hergestellt werden.

Auf diese so aufgetragene Elektrode werden dann die funktionellen Schichten abgeschieden. Für die angegebenen Verwendungszwecke sind dies in der Regel Schichten aus ferroelektrischen Perowskiten wie Blei-Zirkon-Titanat bzw. dotierte Varianten hiervon wie Blei-Magnesium-Niob-Titanat, weiterhin Bariumtitanat, Kombinationen von SiO₂ mit Si₃N₄ oder auch pyroelektrische Schichten aus PbSc_{0.5}Ta_{0.5}O₃. Weitere funktionelle Schichten sind dem Fachmann bekannt. Diese Schichten werden bevorzugt ebenfalls mit einem naßchemischen Depositionsverfahren abgeschieden, beispielsweise im Sol-Gel-Verfahren. Möglich sind aber auch andere Methoden wie Sputtern oder Laser-Ablation.

Nachdem diese Schichten abgeschieden worden sind, müssen sie einer Temperaturbehandlung unterworfen werden. Typische Werte sind 400-700°C für 1 min bis 1 Stunde.

Auf diese funktionellen Schichten wird dann eine Zwischenelektrode und weitere funktionelle Schichten oder die Deckelektrode aufgetragen. Die Deckelektrode kann eine Elektrode nach dem Stand der Technik, z.B. aus gesputtertem Pt sein. Eine Deckelektrode nach der Erfindung, die naßchemisch abgeschiedene leitfähige oxidische Verbindungen enthält, sollte ebenfalls einen hohen Anteil an Edelmetallen enthalten. Anschließend wird die Deckelektrode durch ein lithographisches Verfahren, Jonenätzen oder ähnliche Verfahren strukturiert. Daraufhin wird das Bauteil einer weiteren Temperaturbehandlung unterzogen und dann gegebenenfalls die funktionelle Schicht noch weiter strukturiert.

### Ausführungsbeispiel 1

### Abscheidung einer dünnen RuOₓ-Schicht auf einem Si-Substrat mittels Schleuderverfahren

Zur Abscheidung einer dünnen RuOₓ Schicht wurden 0.3171 g Ruthenium-nitrosyl-nitrat in 5 ml 1-Propanol gelöst und durch ein Teflonfilter mit einer Porenweite von 0.2 µm filtriert. Die so hergestellte Lösung wurde auf ein Si-(100)-Substrat aufgebracht, welches eine 0.5 µm dicke SiO₂-Schicht, hergestellt durch thermische Oxidation, enthielt. Nach der Beschichtung wurde das Substrat auf einer Heizplatte bei 350°C 3 Minuten thermisch behandelt. Nach dieser Behandlung hatte sich eine dünne, kristalline, feinkörnige RuOₓ-Schicht mit einer Schichtdicke von ca. 0.03 µm ausgebildet. Zur Erreichung einer Schichtdicke von ca. 0.1 µm wurde der Beschichtungsprozeß zweimal wiederholt.

Die rutheniumhaltige Schicht besteht aus unterstöchiometrischem RuOₓ, das schon bei sehr niedrigen Temperaturen zunächst ein stark fehlgeordnetes Oxid, dann Elektrodenschichten von hoher Kristallinität, gut vernetzter Morpholgie und metallischer Leitfähigkeit bildet.

### Ausführungsbeispiel 2

### Abscheidung einer dünnen Pb₂Ru₂O₇-Schicht auf einem Si-Substrat mittels Schleuderverfahren

Zur Abscheidung einer dünnen Pb₂Ru₂O₇-Schicht wurden 0.3171 g Ruthenium-nitrosyl-nitrat und 0.3243 g Bleiacetat (63.9 Gew% Pb) werden in 5 ml 1-Propanol gelöst und durch ein Teflonfilter mit einer Porenweite von 0.2 µm filtriert. Die so hergestellte Lösung wurde auf ein Si-(100)-Substrat aufgebracht, welches ein 0.5 µm dicke SiO₂-Schicht, hergestellt durch thermische Oxidation enthielt. Nach der Beschichtung wurde das Substrat auf einer Heizplatte bei 350°C 3 Minuten thermisch behandelt. Nach dieser Behandlung hatte sich eine dünne Pb₂Ru₂O₇-Schicht ausgebildet. Zur Erhöhung der Schichtdicke wurde der Beschichtungsprozeß mehrmals wiederholt.

### Ausführungsbeispiel 3

### Abscheidung einer PbZrₓTi₁₋ₓO₃-Schicht auf einer RuOₓ- Schic ht.

Zur Abscheidung einer PbZrₓTi₁₋ₓO₃-Schicht auf dem nach Ausführungsbeispiel 1 hergestellten Substrat mit einer leitenden RuOₓ-Schicht als Unterelektrode wurden folgende Lösungen hergestellt. Zur Abscheidung einer ersten PbZrₓTi₁₋ₓ O₃-Schicht mit der Zusammensetzung PbZr_{0.35}Ti_{0.65}O₃ wurden 17.97 g Bleiacetat-tri-hydrat (54.8 Gew%. Pb) in 60 g Methoxyethanol gelöst und zu dieser Lösung 9,34 g Titan-tetra-n-butylat (14.1 Gew%. Ti) und 6.57 g Zirkon-tetra-n-butylat (20.53 Gew% Zr) zugefügt. Diese Lösung wurde homogen gemischt. Die einen Bleiüberschuß enthaltende Lösung wurde nach 24 Stunden durch ein Teflonfilter mit einer Porenweite von ca. 0.2 µm filteriert. Mit dieser Lösung der Zusammensetzung Pb:Zr:Ti= 1,1:0.35:0.65 wurde ein Substrat, hergestellt entsprechend dem Ausführungbeispiel 1 beschichtet. Die Lösung erfolgt durch Aufschleudern der Lösung auf das Substrat bei 2500 Umdrehungen pro Minute. Das beschichtete Substrat wurde mit ca. 350°C/min auf 550°C aufgeheizt, 1 Stunde bei dieser Temperatur gehalten und dann mit ca. 350 °C/ min abgekühlt.
Auf diese Perowskitschicht wurde eine weitere Perowskitschicht der Zusammensetzung PbZr_{0.53}Ti_{0.47}O₃ abgeschieden. Dazu wurde eine Lösung auf folgende Weise hergestellt. 9,41 g Bleiacetat (63.9 Gew.% Pb) wurden in 13 ml Methoxyethanol gelöst. 4.22 g Titan-tetra-n-butylat ( 14.1 Gew. % Ti) und 6.57 g Zirkon-tetra-n-butylat (20.53 Gew.%) wurden in 3 ml Methoxyethanol gelöst. Die Titan- und Zirkon enthaltende Lösung wurde zu der Bleiacetatlösung unter Rühren zugefügt. Diese Lösung enthält eine Bleiüberschuß. Weiterhin wurde eine Hydrolisierlösung aus 0.71 ml aq. dest., 0.37 ml conc. HNO3 und 26.4 ml Methoxyethanol hergestellt. Diese Hydrolisierlösung wurde zu der blei-, titan-, zirkonhaltigen Lösung zugefügt. Die so vorhydrolisierte Lösung wurde durch ein Teflonfilter mit einer Porenweite von 0.2 µm filtriert.
Die Lösung wurde auf die oben beschriebene PbZr_{0.35}Ti_{0.65}O₃-Schicht aufgebracht. Die Lösung mit der Zusammensetzung Pb:Zr:Ti=1.1:0.53:0.47 wurde mittels Schleudern bei 2500 Umdrehungen pro Minute homogen verteilt und bei 600°C umgesetzt. Danach wurde die Schicht mit 5°C/ min auf 650°C aufgeheizt und 30 Minuten bei dieser Temperatur behandelt. Die hier beschriebene Schichtanordnung ist von Bedeutung für die Herstellung von ferroelektrischen Speicherzellen mit geringen Ermüdungserscheinungen.

### Ausführungsbeispiel 4

### Abscheidung einer PbZrₓTi₁₋ₓO₃-Schicht zwischen zwei leitenden RuOₓ-Schichten

Zur Abscheidung einer Kondensatoranordnung für ferroelektrischen, nichtflüchtige Speicherzellen mit geringen Ermüdungserscheinungen wird eine PbZrₓTi₁₋ₓO₃-Schicht zwischen zwei leitende oxidische Elektroden, eine Unterelektrode und eine Oberelektrode, gestapelt.
Eine leitende oxidische RuOₓ-Schicht wurde zu diesem Zweck entsprechend auf einem Si Substrat mit einer 0.5 m dicken SiO2-Schicht abgeschieden. Der RuOₓ-Beschichtungsprozeß entspricht Ausführungsbeipsiel 1. Auf diese Schicht wurde eine PbZr_{0.35}Ti_{0.65}O₃ -Schicht und eine PbZr_{0.53}Ti_{0.47}O₃ -Schicht entsprechend dem Ausführungsbeispiel 3 aufgebracht. Auf die PbZr_{0.53}Ti_{0.47}O₃ -Schicht wurde wiederum eine ca. 0.1 µm dicke RuOₓ-Schicht entsprechend dem Ausführungsbeispiel 1 aufgebracht.

### Ausführungsbeispiel 5

### Abscheidung einer PbMg_{0.33}Nb_{0.67}O₃-Schicht auf einer RuOₓ-Schicht.

Zur Herstellung von Dünnschichtkondensatoren, welche eine gute Haftung zu Substraten wie z.B. Si/SiO₂, Al₂O₃, Glas, Quarz zeigen, wurde auf eine Si-Substrat mit einer 500 nm dicken SiO₂-Schicht nach Ausführungsbeispiel 1 eine 0.1 m dicke RuOₓ-Schicht abgeschieden. Darauf wurde eine entsprechend dem Ausführungsbeispiel 3 eine PbZr_{0.35}Ti_{0.65}O₃-Schicht mittels Schleudern abgeschieden. Diese Beschichtung wurde eine Minute bei 650°C gesintert. Auf diese Perowskitschicht wurde eine Pb(Mg0.33Nb0.67)0.65Ti0.45O3 Schicht im Sol-Gelverfahren abgeschieden. Für die Be schichtungslösung wurden 1.822 g Magnesiumethoxid (21.46 Gew% Mg), 10.24 g Niobethoxid (29.64 Gew%. Nb) und 7.46 g Titan-iso-propoxid (16.86 Gew% Ti) in 104 g Ethylenglykolmonomethylether gelöst und 24 Stunden unter Rückfluß erhitzt. Weiterhin wurden 56.93 g Bleiacetat (63.85 Gew% Pb) in 185 g Ethylenglykolmonomethylether gelöst. 61.12 g der Mg-Nb-Ti-Lösung wurden mit 56.26 g der Bleiacetatlösung unter Rühren vermischt und 20 h unter Rückfluß erhitzt. Dann wurde die Blei im Überschuß enthaltende Lösung durch ein Teflonfilter mit einer Porenweite von 0.2 µm filtriert und das Filtrat im Schleuderverfahren bei 2500 Umdrehungen pro Minute auf das oben vorpräparierte Substrat aufgebracht. Diese Beschichtung wurde eine Minute bei 650°C gesintert. Diese Beschichtung mit einer Pb(Mg0.33Nb0.67)O3-Schicht wurde sechsmal wiederholt.

### Ausführungsbeispiel 6

### Abscheidung einer Pb_{0.82}La_{0.12}Zr_{0.7}Ti_{0.3}O₃-Schicht auf einer RuOₓ-Schicht.

Zur Herstellung von Dünnschichtkondensatoren, welche eine hohe Flächenkapazität und eine gute Haftung zu Substraten wie z.B. Si/SiO₂, Al₂O₃, Glas, Quarz zeigen, wurde auf eine Si-Substrat mit einer 500 nm dicken SiO₂-Schicht nach Ausführungsbeispiel 1 eine 0.1 m dicke RuOₓ-Schicht abgeschieden. Darauf wurde ensprechend dem Ausführungsbeispiel 3 eine PbZr_{0.35}Ti_{0.65}O₃ -Schicht mittels Schleudern abgeschieden. Auf diese Perowskitschicht wurde eine Pb_{0.82}La_{0.12}Zr_{0.7}Ti_{0.3} O₃-Schicht mittels Sol-Gel abgeschieden. Dazu wurden eine Lösung hergestellt. Für die Beschichtung wurden 8.118 g Bleiacetat (63.85 Gew% Pb) in in 30 ml Methoxyethanol gelöst. 7.714 g Zirkon-n-propoxid (20.68 Gew% Zr), 2.131 g Titan-iso-propoxid (16.85 Gew% Ti) und 1.28 g Lanthanacetathydrat (32.3 Gew% La) wurden zu der Pb-Lösung zugefügt. Die Blei im Überschuß enthaltende Lösung wurde homogen vermischt, im Verhältnis 1:1 mit Methoxyethanol verdünnt und anschließend durch eine Celluloseacetatfilter mit einer Porenweite von 0.2 µm filtriert. Das Filtrat wurde im Schleuderverfahren mit 2000 Umdrehungen pro Minute auf dem Substrat mit RuOₓ und PbZr_{0.35}Ti_{0.65}O₃-Schicht verteilt. Diese Beschichtung wurde im Diffusionsofen mit Sauerstoffatmosphäre mit ca.
400°C/min auf 700°C aufgeheizt, 40 Minuten bei 700°C gehalten und dann mit ca. 400°C/min abgekühlt. Dieser Beschichtungsschritt kann je nach gewünschter Schichtdicke mehrmals wiederholt werden. Nach dem letzten Beschichtungsauftrag wird zur Endbehandlung zunächst mit 400°C/min auf 700°C aufgeheizt, 40 Minuten gehalten dann mit 5▲C/min auf 750°C aufgeheizt, eine Stunde bei 750°C gehalten und dann mit 400°C/min abgekühlt.

### Ausführungsbeispiel 7

### Abscheidung einer Pb_{0.82}La_{0.12}Zr_{0.7}Ti_{0.3}O₃-Schicht auf einer Pb₂Ru₂O₇-Schicht.

Zur Herstellung von Dünnschichtkondensatoren wurden auf ein Si-Substrat mit einer 500 nm dicken SiO₂-Schicht nach Ausführungsbeispiel 2 eine 0.1 µm dicke Pb₂Ru₂O₇-Schicht abgeschieden. Darauf wurde entsprechend dem Ausführungsbeispiel 3 eine PbZr_{0.35}Ti_{0.65}O₃-Schicht mittels Schleudern abgeschieden. Auf diese Perowskitschicht wurde eine Pb_{0.82}La_{0.12}Zr_{0.7}Ti_{0.3}O₃-Schicht mittels Sol-Gel abgeschieden entsprechend Ausführungsbeispiel 7.

### Ausführungsbeispiel 8

### Abscheidung einer Pb_{0.93}La_{0.05}Zr_{0.53}Ti_{0.47}O₃-Schicht auf einer Pb₂Ru₂O₇-Schicht.

Zur Abscheidung einer Pb_{0.93}La_{0.05}Zr_{0.53}Ti_{0.47}O₃-Schicht für piezoelektrische Anwendungen wurde auf eine Si-Substrat mit einer 500 nm dicken SiO₂-Schicht nach Ausführungsbeispiel 2 eine Pb₂Ru₂O₇-Schicht abgeschieden. Darauf wurde ensprechend dem Ausführungsbeispiel 3 eine PbZr_{0.35}Ti_{0.65}O₃-Schicht mittels Schleudern abgeschieden. Auf diese Perowskitschicht wurde eine Schicht aus Pb_{0.93}La_{0.05}Zr_{0.53}Ti_{0.47}O₃ mittels Sol-Gel-Verfahren abgeschieden. Dazu wurden eine Lösung hergestellt. Für die Beschichtung wurden 10.0 g Bleiacetat (63.85 Gew% Pb) in 35 ml Methoxyethanol gelöst. 6.480 g Zirkon-n-propoxid (20.68 Gew% Zr) wurden in 7 ml Methoxyethanol gelöst. Zu dieser Zirkon enthaltenden Lösung wurden 3.701 g Titan-tetra-n-butylat (14.1 Gew% Ti) und 0.596 g Lanthanacetathydrat (32.3 Gew% La) zugefügt. Die Blei im Überschuß enthaltende Lösung wurde homogen vermischt, anschließend im Verhältnis 1:1 mit Methoxyethanol verdünnt und durch eine Teflonfilter mit einr Porenweite von 0.2 µm filtriert. Das Filtrat wurde im Schleuderverfahren mit 2000 Umdrehungen pro Minute auf dem Substrat mit Pb₂Ru₂O₇ und PbZr_{0.35}Ti_{0.65}O₃-Schicht verteilt. Diese Beschichtung wurde im Diffusionsofen mit Sauerstoffatmosphäre mit ca. 400°C/min auf 700°C aufgeheizt, 1Stunde bei dieser Temperatur gehalten und dann mit ca. 400°/min abgekühlt. Dieser Beschichtungsprozeß wurde je nach gewünschter Schichtdicke mehrmals wiederholt. Bei dem letzten Beschichtungsprozeß wurde die Schicht mit 400°C/min auf 700°C aufgeheizt, 40 Minuten bei dieser Temperatur gehalten dann mit 5°C/min auf 750°C aufgeheizt, eine Stunde bei 750°C behandelt und dann mit 400°C/min abgekühlt.

### Ausführungsbeispiel 9

### Abscheidung einer Sr_{0.5}La_{0.5}CoO₃-Schicht sowie einer PbZrₓTi₁₋ₓO₃-Schicht auf einem Si-Substrat mittels Schleuderverfahren

Zur Abscheidung einer dünnen Sr_{0.5}La_{0.5}CoO₃-Schicht wurden 1.0270 g Strontiumoktoat (9.38 Gew% Sr) und 1.3297 g Cobaltnaphthenat in 16 ml Butanol und 3 ml Methanol gelöst. Zu dieser Lösung werden 0.4847 g Lanthanacetylacetonat zugefügt, die Lösung wurde 24 Stunden homogen vermischt und dann durch ein Teflonfilter mit einer Porenweite von 0.2 µm filtriert. Die hergestellte Lösung wurde auf ein Si (100) Substrat aufgebracht, welches ein 0.5 m dicke SiO₂-Schicht, hergestellt durch thermische Oxidation enthielt. Nach der Beschichtung wurde das Substrat 30 Minuten bei 600°C behandelt. Dieser Beschichtungsprozeß wurde 5 mal wiederholt.
Auf dieses Substrat wurde entsprechend dem Ausführungsbeispiel 3 zunächst eine dünne PbZr_{0.35}Ti_{0.65}O₃-Schicht und anschließend eine dünne PbZr_{0.53}Ti_{0.47}O₃-Schicht abgeschieden. Diese Schichtpakete haben besondere Bedeutung für die Entwicklung von ferroelektrischen nichtflüchtigen Speicherzellen mit geringen Ermüdungserscheinungen. Elektrodenschichten mit La_{0.5}Sr_{0.5}CoO₃ fördern das epitaktische Aufwachsen der perowskitischen funktionellen Schichten und beeinflussen deren Eigenschaften positiv.

### Ausführungsbeispiel 10

### Abscheidung einer Sr_{0.5}La_{0.5}CoO₃-Schicht, einer PbZrₓTi₁₋ₓO₃-Schicht sowie einer Sr_{0.5}La_{0.5}CoO₃-Schicht auf einem Si-Substrat mittels Schleuderverfahren

Zur Entwicklung ferroelektrischer Speicherzellen mit geringen Ermüdungserscheinungen wurde ein Aufbau bestehend aus Si-Substrat, 500 nm dicker SiO₂-Schicht, einer Sr_{0.5}La_{0.5}CoO₃ Schicht sowie einer PbZr_{0.35}Ti_{0.65}O₃-Schicht und einer PbZr_{0.53}Ti_{0.47}O₃Schicht entsprechend Ausführungsbeispiel 10 hergestellt. Auf die Pb_{0.53}Ti_{0.47}O₃-Schicht wurde wiederum mittels Schleudern eine dünne Sr_{0.5}La_{0.5}CoO₃-Schicht aufgebracht. Dazu wurde eine entsprechend Ausführugnsbeispiel 10 hergestellte Lösung auf die Pb_{0.53}Ti_{0.47}O₃-Schicht aufgebracht und bei 2000 Umdrehungen pro Minute homogen verteilt. Nach der Beschichtung wurde dieser Aufbau 30 Minuten bei 600°C behandelt. Dieser Beschichtungsprozeß wurde 5 mal wiederholt.

### Ausführungsbeispiel 11

### Abscheidung einer PbZrₓTi₁₋ₓO₃-Schicht auf einer RuOₓSchicht.

Zur Abscheidung einer PbZr_{0.48}Zr_{0.52}O₃-Schicht für pyroelektrische Anwendungen wird auf eine Si Substrat mit einer 500 nm dicken SiO₂-Schicht eine RuOₓ-Schicht entsprechend Ausführungsbeispiel 1 abgeschieden. Auf diese RuOₓ-Schicht wird eine ca. 0.1 m dicke PbZr_{0.35}Ti_{0.65}O₃-Schicht mit der in Ausführungsbeispiel 3 beschriebenen Lösung abgeschieden.

Die Lösung wird mit 2500 Umdrehungen pro Minute durch einen Schleuderprozeß abgeschieden. Zur Bildung der PbZr_{0.35}Ti_{0.65}O₃-Schicht wird der Aufbau in einem Diffusionsofen mit ca. 350°C/min auf 550°C aufgeheizt, 1 Stunde bei dieser Temperatur gehalten und dann mit ca. 350°C abgekühlt. Zur Abscheidung einer Perowskitschicht der Zusammensetzung PbZr_{0.48}Ti_{0.52}O₃ auf diese PbZr_{0.35}Ti_{0.65}O₃-Schic ht wird eine Lösung auf folgende Weise hergestellt. 8.650 g Bleiacetat (63.9 Gew% Pb) wurden in 13.1 ml Methoxyethanol gelöst. 4..204 g Titan-teta-n-butylat (14.1 Gew.% Ti) und 5.076 g Zirkon-teta-n-butylat (20.53 Gew% Zr) wurden in 3 ml Methoxyethanol gelöst. Die Titan und Zirkon enthaltende Lösung wurde zur Bleiacetatlösung unter Rühren zugefügt. Weiterhin wurde eine Hydrolisierlösung aus 0.64 ml aq. dest., 0.33 ml conc. HNO₃ und 26.4 ml Methoxyethanol hergestellt. Diese Hydrolisierlösung wurde zu der Blei-, Titan- und Zirkon enthaltenden Lösung zugefügt. Die so vorhydrolisierte Lösung wurde durch ein Teflonfilter mit einer Porengröße von 0.2 µm filtriert. Diese Blei im Überschuß enthaltende Lösung wurde dann mittels Schleudern bei 2500 Umdrehungen pro Minute homogen auf dem Substrat mit der Zusammensetzung PbZr_{0.35}Ti_{0.65}O₃ verteilt. Dieser Aufbau wurde bei 600°C eine Stunde eingebrannt. Dieser Beschichtungsprozeß kann je nach gewünschter Schichtdicke mehrmals wiederholt werden. Bei dem letzten Beschichtungsprozeß wird die Schicht eine Stunde bei 600°C vorgebrannt, dann mit 5°C/min auf 650°C aufgeheizt und bei dieser Temperatur 30 Minuten behandelt.

### Ausführungsbeispiel 12

### Abscheidung einer dünnen SrRu₃3-Schicht auf einem Si-Substrat mittels Schleuderverfahren

Zur Abscheidung einer dünnen SrRuO₃-Schicht wurden 0.2357g Strontium-iso-propoxid (37.18 Gew.% Sr) in 2 ml Methoxyethanol gelöst. 0.3171 g Ruthenium-nitrosyl-nitrat wurden in 3 ml Methoxyethanol gelöst. Beide Lösungen wurden unter Rühren zusammengefügt und anschließend durch ein Teflonfilter mit einer Porenweite von 0.2 µm filtriert. Die so hergestellte Lösung wurde auf ein Si (100) Substrat aufgebracht, welches ein 0.5 µm dicke SiO₂-Schicht, hergestellt durch thermische Oxidation, enthielt. Nach der Beschichtung wurde das Substrat auf einer Heizplatte bei 350°C 3 Minuten thermisch behandelt. Zur Erreichung einer gewünschten Schichtdicke wurde der Beschichtungsprozeß mehrmals wiederholt.

### Ausführungsbeispiel 13

### Abscheidung einer Pb_{0.82}La_{0.12}Zr_{0.7}Ti_{0.3}O₃-Schicht auf einer-SrRuO₃-Schicht.

Zur Herstellung von Dünnschichtkondensatoren, welche eine hohe Flächenkapazität und eine Haftung zu Substraten wie z.B. Si/SiO₂, Al₂O₃, Glas, Quarz zeigen, wurde auf ein Si-Substrat mit einer 500 nm dicken SiO2 Schicht nach Ausführungsbeispiel 14 eine SrRuO₃-Schicht abgeschieden. Darauf wurde ensprechend dem Ausführungsbeispiel 3 eine PbZr_{0.35}Ti_{0.65}O₃-Schicht mittels Schleudern abgeschieden. Auf diese Perowskitschicht wurde eine Pb_{0.82}La_{0.12}Zr_{0.7}Ti_{0.3}O₃-Schicht mittels Sol-Gel-Verfahren abgeschieden. Dazu wurden eine Lösung hergestellt entsprechend Ausführungsbeispiel 7 hergestellt. Die Lösung wurde im Schleuderverfahren mit 2000 Umdrehungen pro Minute auf dem Substrat mit SrRuO₃ und PbZr_{0.35}Ti_{0.65}O₃- Schicht verteilt. Diese Beschichtung wurde im Diffusionsofen mit Sauerstoffatmosphäre eine Minute bei ca. 750°C gesintert. Die Beschichtung mit einer Pb_{0.82}La_{0.12}Zr_{0.7}Ti_{0.3}O₃-Schicht wurde 4 mal wiederholt.

### Ausführungsbeispiel 14

### Abscheidung einer dünnen BaRuO₃-Schicht auf einem Si-Substrat mittels Schleuderverfahren

Zur Abscheidung einer dünnen BaRuO₃-Schicht wurden 0.31572 g Bariumethoxid (43.5 Gew.% Ba) in 5 ml Methoxyethanol gelöst. Zu dieser Lösung wurden 0.3171 g Ruthenium -nitrosyl-nitrat zugefügt. Die Lösung wurde durch ein Teflonfilter mit einer Porenweite von 0.2 µm filtriert. Die hergestellte Lösung wurde auf ein Si (100) Substrat aufgebracht, welches ein 0.5 µm dicke SiO2 Schicht, hergestellt durch thermische Oxidation enthielt. Nach der Beschichtung wurde das Substrat auf einer Heizplatte bei 350°C 3 Minuten thermisch behandelt. Zur Erreichung einer ge-wünschten Schichtdicke wurde der Beschichtungsprozeß mehrmals wiederholt.

### Ausführungsbeispiel 15

### Abscheidung einer Pb(Mg_{0.33}Nb_{0.67})_{0.65}Ti_{0.35}O₃-Schicht auf einer BaRuO3 Schicht.

Zur Herstellung von Dünnschichtkondensatoren, welche eine gute Haftung zu Substraten wie z.B. Si/SiO₂, Al₂O₃, Glas, Quarz zeigen wurde auf eine Si-Substrat mit einer 500 nm dicken SiO₂-Schicht nach Ausführungsbeispiel 15 eine BaRuO₃-Schicht abgeschieden. Darauf wurde eine entsprechend dem Ausführungsbeispiel 3 eine PbZr_{0.35}Ti_{0.65}O₃-Schicht mittels Schleudern abgeschieden. Diese Beschichtung wurde eine Minute bei 650°C gesintert. Auf diese Perowskit schicht wurde eine Pb(Mg0.33Nb0.67)0.65Ti0.35O3 Schicht im Sol-Gelverfahren abgeschieden. Für die Beschichtungslösung wurde entsprechend Ausführungsbeispiel 6 verfahren. Die Lösung wurde im Schleuderverfahren bei 2500 Umdrehunen pro Minute auf das oben vorpräparierte Substrat aufgebracht. Diese Beschichtung wurde eine Minute bei 650°C gesintert.

Die Beschichtung mit einer Pb(Mg_{0.33}Nb_{0.67})_{0.65}Ti_{0.35}O₃-Schicht wurde sechsmal wiederholt.

### Ausführungsbeispiel 16

### Abscheidung einer dünnen (RuOₓ)_{0.7}(TiO₂)_{0.3}-Schicht auf einem Si-Substrat

Zu Abscheidung einer dünnen (RuOₓ)_{0.7}(TiO₂)_{0.3}-Schicht wurden 0.3171 g Ruthenium-nitrosyl-nitrat und 0.1459 g Titantetra-n-butylat in 5ml 1-Propanol gelöst. Die Lösung wurde durch ein Teflonfilter mit einer Porenweite von 0.2µm filtriert. Die so hergestellte Lösung wurde auf ein Si(10 0)-Substrat aufgebracht, welches eine 0.5µm dicke SiO₂-Schicht aufwies. Nach der Beschichtung wurde das Substrat auf eine Heizplatte bei 350°C 3 Minuten thermisch behandelt. Zur Erreichung der gewünschten Schichtdicke wurde der Prozeß mehrmals wiederholt.

### Ausführungsbeispiel 17

### Abscheidung einer dünnen leitenden Schicht aus RuOₓ und Pt auf einem Si-Substrat

Zur Abscheidung einer dünnen, elektrisch leitenden Schicht bestehend aus RuOₓ und metallischem Pt wurden 0.3171g Ruthenium-nitrosyl-nitrat und 0.1966g Platin-acetylacetonat in 8 ml Methoxyethanol gelöst. Die Lösung wurde durch ein Teflonfilter mit einer Porenweite von 0.2µm filtriert. Die so hergestellte Lösung wurde auf ein Si(10 0)-Substrat aufgebracht, welches eine 0.5µm dicke SiO₂-Schicht aufwies. Nach der Beschichtung wurde das Substrat im Ofen bei 600°C 1 Minute thermisch behandelt. Zur Erreichung der gewünschten Schichtdicke wurde der Prozeß mehrmals wiederholt.

### Ausführungsbeispiel 18

### Abscheidung einer dünnen leitenden Schicht aus RuOₓ und Pt auf einem Si-Substrat

Zur Abscheidung einer dünnen, elektrisch leitenden Schicht bestehend aus RuOₓ und metallischem Pt wurden 0.3171g Ruthenium-nitrosyl-nitrat und 0.3044g Platin-hexa-fluoracetylacetonat in 8 ml Methoxyethanol gelöst. Die Lösung wurde durch ein Teflonfilter mit einer Porenweite von 0.2µm filtriert. Die so hergestellte Lösung wurde auf ein Si(100)-Substrat aufgebracht, welches eine 0.5µm dicke SiO₂-Schicht aufwies. Nach der Beschichtung wurde das Substrat auf einer Heizplatte bei 350°C 3 Minuten thermisch behandelt. Zur Erreichung der gewünschten Schichtdicke wurde der Prozeß mehrmals wiederholt. Danach wurde eine Endbehandlung im Ofen bei 650°C durchgeführt.

### Ausführungsbeispiel 19

### Abscheidung einer dünnen leitenden Schicht aus RuOₓ und Pd auf einem Si-Substrat

Zur Abscheidung einer dünnen, elektrisch leitenden Schicht bestehend aus RuOₓ und metallischem Pd wurden 0.3171g Ruthenium-nitrosyl-nitrat in 5 ml 1-Propanol gelöst. 0.09g Palladiumacetat wurden in 2ml Essigsäure gelöst. Die Palladium enthaltende Lösung wurde zu der Rutheniumlösung zugefügt. Die Pd-Ru-Lösung wurde durch ein Teflonfilter mit einer Porenweite von 0.2µm filtriert. Die so hergestellte Lösung wurde auf ein Si(100)-Substrat aufgebracht, welches eine 0.5µm dicke SiO₂-Schicht aufwies. Nach der Beschichtung wurde das Substrat bei einer Temperatur von 550°C 30 Minuten thermisch behandelt. Zur Erreichung der gewünschten Schichtdicke wurde der Prozeß mehrmals wiederholt. Danach wurde eine Endbehandlung im Ofen bei 600°C angeschlossen.

### Ausführungsbeispiel 20

### Abscheidung einer dünnen leitenden Schicht aus RuOₓ und Pd auf einem Si-Substrat

Zur Abscheidung einer dünnen, elektrisch leitenden Schicht bestehend aus RuOₓ und metallischem Pd wurden 0.3171g Ruthenium-nitrosyl-nitrat und 0.1520g Palldium-acetylacetonat in 8 ml Methoxyethanol gelöst. Die Lösung wurde durch ein Teflonfilter mit einer Porenweite von 0.2µm filtriert. Die so hergestellte Lösung wurde auf ein Si(10 0)-Substrat aufgebracht, welches eine 0.5µm dicke SiO₂-Schicht aufwies. Nach der Beschichtung wurde das Substrat im Ofen bei 600°C 1 Minute thermisch behandelt. Zur Erreichung der gewünschten Schichtdicke wurde der Prozeß mehrmals wiederholt.

### Ausführungsbeispiel 21

### Abscheidung einer dünnen leitenden Schicht aus RuOₓ und Pd auf einem Si-Substrat

Zur Abscheidung einer dünnen, elektrisch leitenden Schicht bestehend aus RuOₓ und metallischem Pd wurden 0.3171g Ruthenium-nitrosyl-nitrat in 5 ml 1-Propanol gelöst. 0.11 53g Palladiumnitrat-Hydrat wurden in 0.144g 2-Ethyhexansäure gelöst. Die Palladium enthaltende Lösung wurde zu der Rutheniumlösung zugefügt und nach dem Vermischen durch ein Teflonfilter mit einer Porenweite von 0.2µm filtriert. Die so hergestellte Lösung wurde auf ein Si(100)-Substrat aufgebracht, welches eine 0.5µm dicke SiO₂-Schicht aufwies. Die erhaltene Schicht wurde bei einer Temperatur von 350°C 5 Minuten thermisch behandelt. Der Beschichtungsprozeß wurde mehrmals wiederholt, bis die gewünschte Schichtdicke erreicht war. Zur Nachbehandlung wurde das Teil im Ofen bei einer Temperatur von 600°C 1 Minute behandelt.

### Ausführungsbeispiel 22

### Abscheidung einer Pb(Sc_{0.5}Ta_{0.5})O₃-Schicht auf einer RuOₓ-Elektrodenschicht

Zur Herstellung einer Pb(Sc_{0.5}Ta_{0.5})O₃-Schicht bei 650°C wurde zunächst auf ein Si-Substrat mit einer 500nm dicken SiO₂-Schicht eine 0.5µm dicke RuOₓ-Schicht wie in Ausführungsbeispiel 1 beschrieben abgeschieden. Darauf wurde entsprechend Ausführungsbeispiel 3 eine Keimschicht aus PbZr_{0.35}Ti_{0.65}O₃ mittels Schleuderverfahren abgeschieden. Diese Beschichtung wurde eine Stunde bei 550°C gesintert. Auf diesen Untergrund wurde eine Pb(Sc_{0.5}Ta_{0.5})O₃-Schicht im Sol-Gel-Verfahren abgeschieden. Für die Beschichtungslösung wurden 2.540g Tantalethoxid (44.5Gew.-%Ta) und 2.152g Scandiumacetylacetonat (12.95Gew.-% Sc) in Ethylenglykolmonomethylether gelöst und 2 Stunden unter Rückfluß erhitzt, dann abgekühlt. danach wurden 4.640 g Bleiacetat (64.1 Gew.-%Pb) zu der Scandium-Tantal-Lösung zugefügt und die Lösung 2 weitere Stunden unter Rückfluß erhitzt. Dann wurde die Lösung durch ein Teflonfilter filtriert und das Filtrat im Schleuderverfahren bei 2500 Umdrehungen pro Minute auf das oben präparierte Substrat aufgebracht. Diese Beschichtung wude eine Stunde bei 600°C im Sauerstoffstrom behandelt. Die Beschichtung mit der Blei-Scandium-Tantal-Lösung wurde 3 mal wiederholt. Zur thermischen Nachbehandlung wurde das Schichtpaket eine Stunde bei 650°C im Sauerstoffstrom behandelt.

## Patentansprüche

1. Elektronisches Dünnschichtbauteil
mit einem Substrat,
mit Elektrodenschichten für Unterelektrode, Deckelektrode und gegebenenfalls ein oder mehreren Zwischenelektroden und mit funktionellen Zwischenschichten,
wobei die Elektrodenschichten elektrisch leitende, oxidische Verbindungen enthalten, dadurch gekennzeichnet,
daß mindestens eine Elektrodenschicht
aus TiOₓ mit 1≦x≦2, EuOₓ mit 1≦x≦2, LiTi₂O₄, LiV₂O₄, SrVO₃, ErₓNbO₃ mit 0,65≦x≦0,92, RbWO₃, NaₓWO₃, A₂P₈W₃₂O₁₁₂ mit A=K, Rb,Tl, NaₓTa_{y}W_{1-y}O₃ mit x=0.64 und x-y= 0.18, Na₁₋ₓSrₓNbO₃, LaTiO₃ CeTiO₃, CaVO₃, La₁₋ₓSrₓVO₃, SrCoO₃, CaRuO₃, SrRuO₃, BaRuO₃, BaPbO₃, SrMoO₃, Sr_{0.5}La_{0.5}O₃, La₄BaCu₅O₁₃₋ₓ, La₂₋ₓSrₓCuO_{4-δ}, YBa₂Cu₃O_{7-δ}, Bi₂Sr₂CaCu₂O_{8+d}, Bi₂Sr₂CuO_{6+d}, Bi₂Sr₂Ca₂Cu₃O_{10+d}, Tl₂Ba₂CaCu₂O₈, TlBa₂CuO_{6+d}, Tl₂Ba₂Ca₂Cu₃O_{10+d}, La₄BaCu₆O₁₅, Gd₁₋ₓSrₓVO₃, CaCrO₃, SrFeO₃, EuNbO₃, SrIrO₃, CaMoO₃, BaMoO₃, Bi₃Ru₃O₁₁, VO₂, CrO₂, MoO₂, WO₂, RhO₂, PtO₂, RuOₓ mit 1,5≦x<2, IrOₓ mit 1,5≦x≦2, SnO₂₋ₓ, La₃Ni₂O₇, La₃Ni₃O₁₀, M₂V₂O₇₋ₓ mit M=Tm, Lu, M₂Mo₂O₇ mit M=Nd,Sm,Gd, Lu₂Ru₂O₇, Pb₂Ru₂O₇, Bi₂Ru₂O₇, Pb₂Os₂O₇, Tl₂Os₂O₇, Pb₂Ir₂O₂, Tl₂Rh₂O₇₋ₓ, K_{0.3}MoO₃, Rb_{0.3}MoO₃, Tl_{0.3}MoO₃ MₓV₂O₅ mit M=Cu,Na, Mo₁₇O₄₇ oder Tl₂O₃₋ₓ oder aus physikalischen Mischungen und/oder festen Lösungen miteinander oder mit ≦ 50 Gew.-% von weiteren Verbindungen oder Metallen besteht.

2. Elektronisches Dünnschichtbauteil nach Anspruch 1,
dadurch gekennzeichnet,
daß die weiteren Verbindungen ReO₃ oder RuO₂ sind.

3. Elektronisches Dünnschichtbauteil nach Anspruch 1 und 2,
dadurch gekennzeichnet,
daß die weiteren Verbindungen TiO₂, SiO₂ oder Al₂O₃ sind.

4. Elektronisches Dünnschichtbauteil nach Anspruch 1 bis 3,
dadurch gekennzeichnet,
daß die weitere Verbindung SnO₂ ist.

5. Elektronisches Dünnschichtbauteil nach Anspruch 1 bis 4,
dadurch gekennzeichnet,
daß die Metalle Platin, Palladium, Iridium, Silber, Gold und/oder Kupfer oder deren Legierungen sind.

6. Elektronisches Dünnschichtbauteil nach Anspruch 1 bis 5,
dadurch gekennzeichnet,
daß die funktionellen Zwischenschichten Perowskite enthalten.

7. Elektronisches Dünnschichtbauteil nach Anspruch 1 bis 6,
dadurch gekennzeichnet,
daß das Substrat aus Si, GaAs, Saphir , Glas , Quarz, ZrO₂, MgO, Al₂O₃ oder AlN besteht.

8. Verfahren zur Herstellung eines elektronischen Dünnschichtbauteils nach Anspruch 1 bis 7,
bei dem eine oder mehrere Elektrodenschichten durch Beschichten eines Substrates oder einer funktionellen Zwischenschicht mit echten Lösungen, Solen oder Suspensionen, die Ausgangsverbindungen für die elektrisch leitenden oxidischen Verbindungen in organischen Lösungsmitteln enthalten, mittels eines naßchemischen Depositionsverfahrens und anschließender thermischen Behandlung zur Bildung der elektrisch leitenden oxidischen Verbindungen erzeugt werden.

9. Verfahren nach Anspruch 8,
dadurch gekennzeichnet,
daß die Ausgangsverbindungen metallo-organische Verbindungen oder nitrat-, halogenid- oder hydroxidhaltige Verbindungen sind.

10. Verfahren nach Anspruch 8 und 9,
dadurch gekennzeichnet,
daß das naßchemische Depositionsverfahren ein Schleuderverfahren ist.

11. Verfahren nach Anspruch 8 bis 10,
dadurch gekennzeichnet,
daß die Beschichtung in mehreren Schichten aufgetragen wird.

12. Verfahren nach Anspruch 11,
dadurch gekennzeichnet,
daß die Mehrfachschichten unterschiedliche Zusammensetzung haben.

13. Verfahren nach Anspruch 1 bis 12,
dadurch gekennzeichnet,
daß die Beschichtung bei erhöhter Temperatur aufgetragen wird.

14. Verfahren nach Anspruch 1 bis 13,
dadurch gekennzeichnet,
daß die funktionellen Schichten mittels eines naßchemischen Depositionsverfahrens und anschließender thermischen Behandlung erzeugt werden.
